# EUROPEAN PATENT SPECIFICATION

(11) **EP 3 159 212 B1**
(45) Date of publication and mention of the grant of the patent: **01.08.2018**
(21) Application number: 16158767.0
(22) Date of filing: 04.03.2016
(51) Int. Cl.: F25B 21/04, H01L 21/00, B60N 3/10, B60N 3/18, F25D 31/00

(54) **CONTAINER ACCOMMODATION APPARATUS**
BEHÄLTERAUFNAHMEVORRICHTUNG
APPAREIL DE LOGEMENT DE RÉCIPIENT

(30) Priority: 20.10.2015 KR 20150146250
(43) Date of publication of application: 26.04.2017
(73) Proprietor: LG Innotek Co., Ltd., Seoul, 04637 (KR)
(72) Inventor: SHIN, Jong Bae, 04637 Seoul (KR); KANG, Jong Hyun, 04637 Seoul (KR); KIM, In Tae, 04637 Seoul (KR); WON, Boone, 04637 Seoul (KR); LIM, Su Chan, 04637 Seoul (KR); JEONG, Seong Hyuk, 04637 Seoul (KR)
(74) Representative: Zardi, Marco

(56) References cited:
- DE-A1-102012 020 822
- US-B1- 6 530 232
- US-B1- 7 089 749

## Description

### [Technical Field]

Embodiments of the present invention relate to a beverage keeping apparatus capable of cooling and warming.

### [Background Art]

Since conventional cup holders installed in vehicles or specific places serve only to fix cups to prevent contents contained in the cups from being spilled due to movements of the vehicles, there is a problem in that the contents contained in the cups, cans, or the like may not be cooled or warmed.

To solve such a problem of a conventional cup holder, although a cup holder capable of cooling and warming has been developed, there are problems in that an inner portion of the cup holder may not be easily controlled at various temperatures, and a cooling mode and a warming mode may not be simultaneously preformed.

Therefore, although a cup holder has been developed using a thermoelectric element, there is a demerit in that a conventional cup holder may not be easily attached or detached because of a built-in structure in which the cup holder is installed during a manufacturing.

In addition, when a cup holder is installed in a vehicle, since a size in which a cup holder is installed is different from a model of the vehicle, there is a problem in that a use range thereof is highly limited except for cup holders which are integrally manufactured with the vehicle.

DE 10 2012 020882 and US 6 530 232 are examples of container accommodation apparatuses.

### [Disclosure]

### [Technical Problem]

The present invention is directed to providing a container accommodation apparatus having a structure capable of providing a cooling or a warming function to a container which accommodates a beverage using a heat absorption or heat generation function of a thermoelectric module, and capable of being installed in various places.

### [Technical Solution]

According to the present invention, a container accommodation apparatus includes an accommodation unit including a container accommodation member configured to accommodate a container therein and a thermoelectric module which is disposed at an external surface of the container accommodation member and applies thermal conversion effect, an extension unit which is coupled to a lower portion of the accommodation unit, extends from an inside to an outside of a case member, and fixes and supports the accommodation unit, and a housing unit which includes a circulation control module which performs control of the thermoelectric module from an outside thereof, and further including the features of claim 1.

### [Advantageous Effects]

According to the embodiment of the present invention, a container accommodation apparatus can be provided, wherein the container accommodation apparatus can provide cooling and warming functions in a container which accommodates a beverage using a heat absorption or heat generation function of a thermoelectric module and can be installed in various places.

Particularly, there are also effects in that versatility is obtained by including an extension unit capable of extending to fit various installation holes regardless of a diameter of a container accommodation member, and a stable fixing force can be obtained using an elastic member.

In addition, when a container accommodation apparatus according to the embodiment of the present invention is applied to a vehicle, since the container accommodation apparatus can be separately detachably installed at a place of a cup holder provided in the vehicle, use convenience can be improved. In addition, since the container accommodation apparatus can be coupled to frames having various sizes, an insertion diameter of the container accommodation apparatus can be varied so that the container accommodation apparatus is easily installed in an existing cup holder in a conventional vehicle, and the container accommodation apparatus can be applied to various vehicle models.

In addition, according to the embodiment of the present invention, by implementing a thermoelectric element which performs a heat generation or heat absorption function in a container accommodation portion in a stacked structure, thermal conductivity is decreased, electric conductivity is increased, and therefore cooling capacity (Qc) and temperature change ratio (ΔT) are significantly improved, a slimmer cup holder can be formed, and space efficiency can be improved.

Particularly, there are also effects in that electric conductivity can be maximized by including a conductive pattern layer between unit members of a stacked structure, and space use can be maximized since a thickness thereof is significantly thinned compared to a conventional bulk type thermoelectric element.

### [Description of Drawings]

FIG. 1 is a perspective view illustrating an accommodation unit of a container accommodation apparatus according to an embodiment of the present invention, and FIG. 2 is an exploded perspective view of the accommodation unit in FIG. 1.
FIG. 3 is an exploded perspective view illustrating the accommodation unit in the structure in FIG. 2, and FIG. 4 is a coupling perspective view of the accommodation unit in FIG. 3.
FIG. 5 is an exploded perspective view illustrating an extension unit according to the embodiment of the present invention, and FIG. 6 is a coupling view of the extension unit in FIG. 5.
FIG. 7 is an exploded perspective view illustrating a structure of a housing unit of the present apparatus illustrated in FIG. 2, and FIG. 8 is a coupling view of the housing unit in FIG. 7.
FIG. 9 is a view of a state of coupling the accommodation unit to the housing unit, and FIG. 10 is a view of a state of coupling the extension unit of the present apparatus to the coupling structure in FIG. 9.
FIG. 11 is a view illustrating a general structure of a thermoelectric module applied to the container accommodation apparatus according to the above-described embodiment of the present invention in the structure in FIG. 2.
FIG. 12 is a view illustrating another embodiment of a manufacturing process of a thermoelectric element according to another embodiment of the present invention.

### [Modes of the Invention]

Hereinafter, a configuration and operations of the present invention will be specifically described with reference to the accompanying drawings. In the description with the accompanying drawings, like reference numerals in the drawings denote like elements, and thus the description thereof will not be repeated. Although the terms first, second, etc. may be used herein to describe various elements, these elements should not be limited by these terms. These terms are used only to distinguish one element from another.

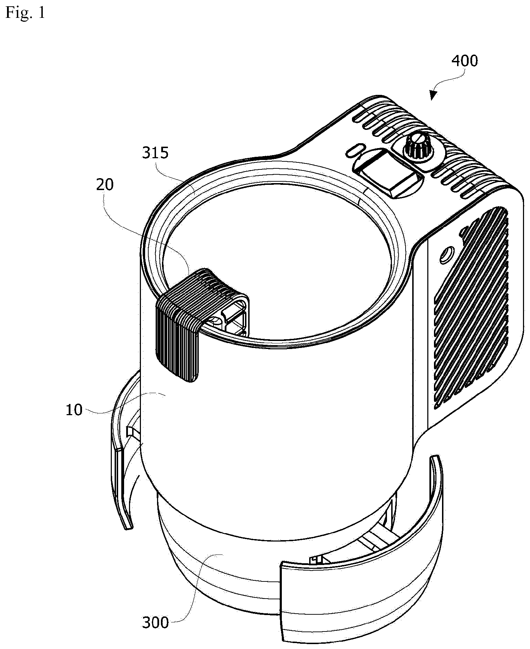

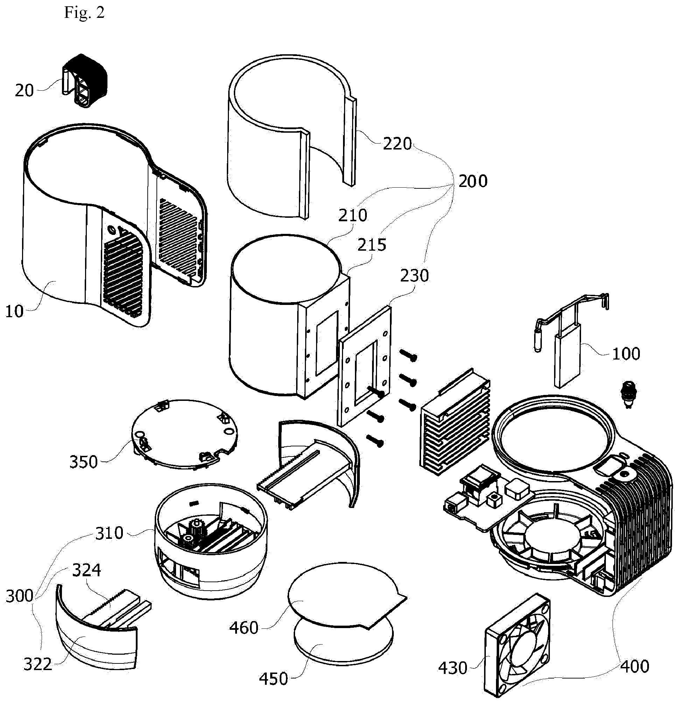

FIG. 1 is a perspective view illustrating an accommodation unit of a container accommodation apparatus according to an embodiment of the present invention, and FIG. 2 is an exploded perspective view of the accommodation unit in FIG. 1.

Referring to FIGS. 1 and 2, a container accommodation apparatus according to an embodiment of the present invention may include a container accommodation member 210 for accommodating a container therein, an accommodation unit 200 disposed at an external surface of the container accommodation member 210 and having a thermoelectric module 100 which applies a thermal conversion effect thereto, an extension unit 300 which is coupled to a lower portion of the accommodation unit 200, extends from an inner side to an outer side of a case member 310, and fixes and supports the accommodation unit 200, and a housing unit 400 in which the accommodation unit 200 is installed and which includes a circulation control module which performs control of the thermoelectric module 100 from an outside thereof.

By the above-described structure, the container accommodation apparatus (hereinafter referred to as 'the present apparatus') according to the embodiment of the present invention may implement a cup holder structure capable of implementing cooling and warming functions using the thermoelectric module, particularly, versatility may be obtained by installing an extension unit capable of extending to fit various installation holes regardless of diameters of installation places, and a stable fixing force may be realized using an elastic member.

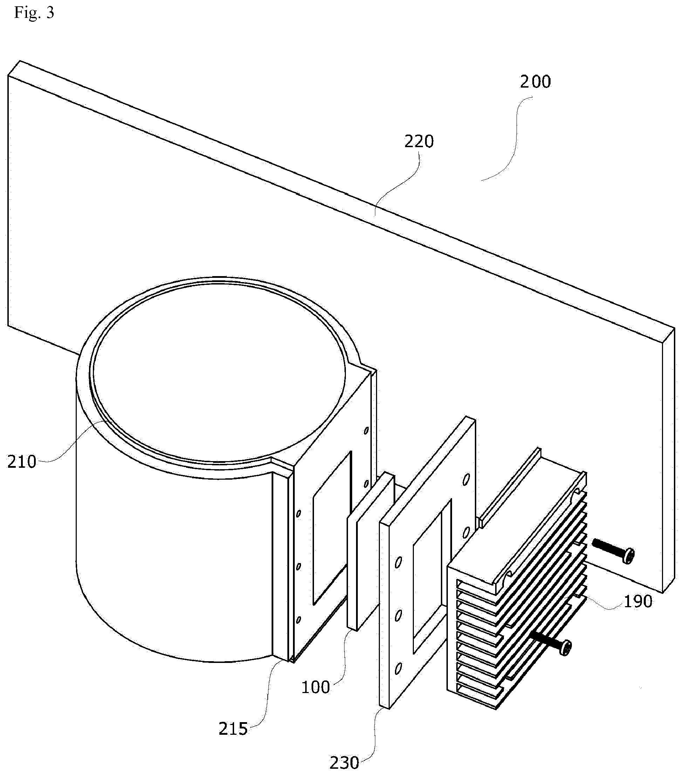

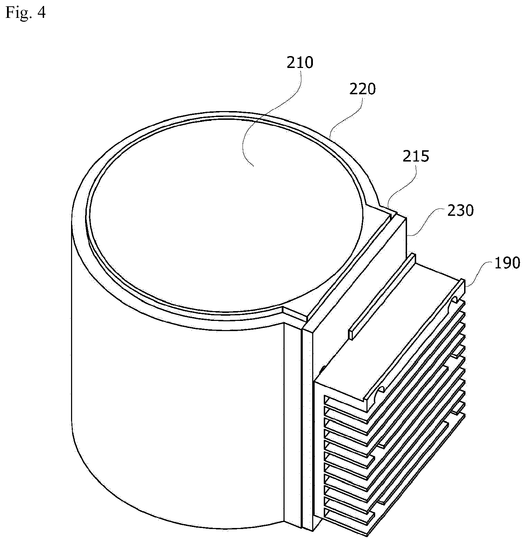

FIG. 3 is an exploded perspective view illustrating the accommodation unit 200 in the structure in FIG. 2, and FIG. 4 is a coupling perspective view of the accommodation unit in FIG. 3. A structure of the accommodation unit of the present invention will be described with reference to FIGS. 3 and 4.

The container accommodation member 210 is disposed in the accommodation unit 200, and the container accommodation member 210 formed with a hollow center is capable of receiving a thermal converting effect realized by the thermoelectric module 100. The container accommodation member 210 is provided with an accommodation portion in a shape whose inside is empty, and a cup or a beverage to be drunken later by a user may be inserted into the accommodation portion and a cooling or warming effect may be realized. To this end, the container accommodation member 210 may be formed of a metal, an alloy, or a synthetic resin material. In the present embodiment, the container accommodation member 210 which is formed of an aluminum material will be described as an example.

The container accommodation member 210 is formed in a cylindrical structure whose surface has curvature, and a part thereof is formed in a flat plate part so that a thermoelectric module seating portion 215 in which the thermoelectric module is installed is provided. That is, the thermoelectric module seating portion 215 having a flat plate shape is provided at a side surface of the container accommodation apparatus, and a heating portion or a heat absorption portion of the thermoelectric module 100 may be disposed to be pressed against the side surface. To improve the property of thermoelectric efficiency, the thermoelectric module 100 may be seated on the thermoelectric module seating portion 215 using thermal grease. Furthermore, as a first thermal insulation member 230 is disposed to be installed at an outer circumferential surface of the thermoelectric module seated on the thermoelectric module seating portion 215, thermal loss to the outside may be prevented. A hole region may be formed in the first thermal insulation member 230 so that the central portion of the first thermal insulation member 230 corresponds to an external shape of the thermoelectric module, and the first thermal insulation member 230 may be coupled by inserting the thermoelectric module into the hole region, and may be installed in the thermoelectric module seating portion 215. Furthermore, to increase heat dissipation efficiency of the thermoelectric module 100, a heat sink 190 may also be additionally attached onto a substrate of the thermoelectric module.

Furthermore, the accommodation unit 200 may further include a second thermal insulation member 220 for thermal insulation of an outer surface of the container accommodation member 210, and as illustrated in FIGS. 3 and 4, the second thermal insulation member 220 may be disposed in a structure which surrounds an entire outer surface of the container accommodation member 210, and may be formed to be in contact with both side ends of the first thermal insulation member 230.

In the present apparatus, a container such as a cup which accommodates a liquid such as a beverage is inserted into the accommodation portion of the container accommodation member 210, the present apparatus functions to heat the container, and an insulation place corresponding to a diameter of the cylindrical container accommodation member is needed for installing the present apparatus in a vehicle, a chair, or the like.

For example, when the present invention is installed in a vehicle, an installation groove which is slightly larger than a diameter of the cylindrical container accommodation member 210 must be installed. However, when such an installation groove is excessively larger than the diameter of the container accommodation member 210, the installation may be performed, but there is a problem in that the container accommodation member 210 is shaken and a beverage overflows or the container accommodation member 210 falls down. To this end, the present apparatus may further include the extension unit 300 coupled to a lower portion of the container accommodation member 210 to obtain a fixing force so that the present apparatus is capable of being widely applied to a space of an installation place.

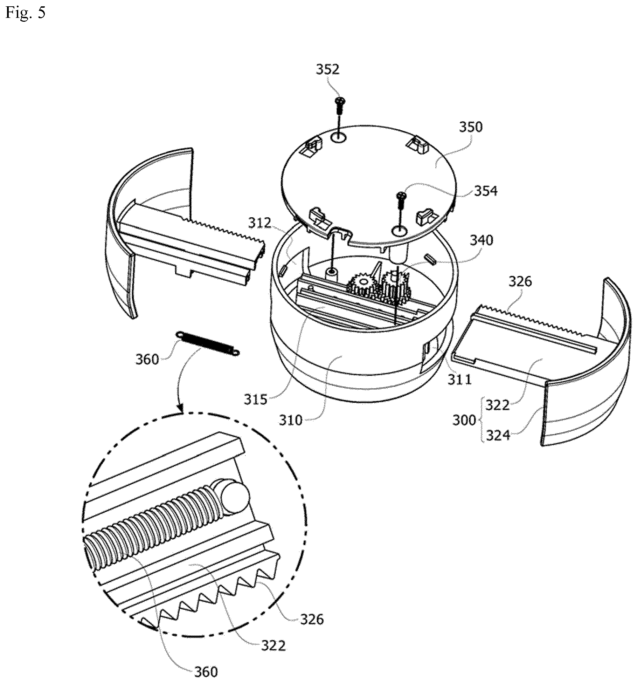

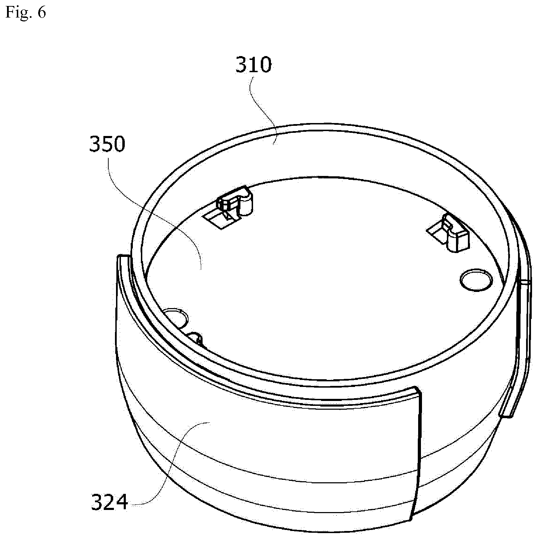

FIG. 5 is an exploded perspective view illustrating such an extension unit 300 according to the embodiment of the present invention, and FIG. 6 is a coupling view of the extension unit in FIG. 5. Referring to FIGS. 5 and 6, the extension unit 300 of the present apparatus may include a case member 310 which is coupled to a lower side of the container accommodation member and in which extension slots 311 and 312 communicated with an inside thereof are formed, and a stopper member 320 provided to be inserted into the case member 310 through the extension slots 311 and 312 of the case member 310. Although in the structure illustrated in FIG. 5, a pair of stopper members 320 are described as an example, at least one or more of the stopper members may be variously provided.

In addition, the stopper member 320 may be formed to be capable of sliding and being inserted into the extension slots 311 and 312 having a through hole type structure formed on an outer wall of the case member 310, and specifically, the stopper member 320 may include a first member 322 which is inserted into an inside thereof from an outside of the case member 310 and in which a stopper pattern 326 is formed on an outer circumferential surface thereof, and a second member 324 which is formed at an end of the first member 322, is disposed at an outside of the case member 310, surrounds a part of the outer circumferential surface of the case member 310, and is larger than an outer diameter of the extension slot.

The first member 322 may be formed in a bar type structure to be easily inserted into or withdrawn from an inside of the case member 310, and a plurality of stopper patterns 326 having a sawlike protrusion shape may be formed at a side surface thereof. Furthermore, the second member 324 may be formed in a structure larger than the extension slot 311 and 312 to be caught by an outer wall surface of the case member when the first member 322 is inserted into the case member 310.

A pair of first members 322 may be provided as illustrated in FIG. 5, and may operate to be inserted into the case member 310 from the outside, the stopper pattern 326 may be formed to engage with a pair of gear members 340 seated in the case member 310. In addition, when an elastic member 360 such as a spring is installed at a side surface of the first member 322, inserted at a predetermined depth, and engaged with the gear member 340, and the first member maintains a fixed state temporarily, and when a surface of the second member 324 is pressed by an external force, an elastic restoring force may be maintained.

That is, as illustrated in FIG. 6, in the extension unit 300 of the present apparatus, when the present apparatus is installed into an installation portion of a vehicle from a state in which the stopper member is completely inserted into the case member 310, and a diameter of hole of the installation portion is greater than that of the container accommodation member, the second member 324 of the stopper member 320 may be pulled toward both sides to be in contact with an outer surface of the installation portion, and the accommodation unit of the present apparatus may be stably fixed. In addition, even when the present invention is installed in an installation place which shakes a lot such as a vehicle, since a constant buffer force is realized due to an operation of the above-described elastic member 360, there is an advantage in that contents therein do not overflow even when shaking is generated.

In addition, as illustrated in FIGS. 5 and 6, a top surface of the case member 310 is covered by a protection cover 350, fixed by fixing members 352, 354, and coupled to a lower portion of the container accommodation member in FIG. 3 in the state in FIG. 6. In the above-described process, a screw thread or a coupling structure for fixing may be formed at an inner surface of an upper side of the case member 310 and may be screwed or insertion coupled to a lower portion of the container accommodation member having a cylindrical structure by turning. Such a coupling type may be realized by various known coupling structures.

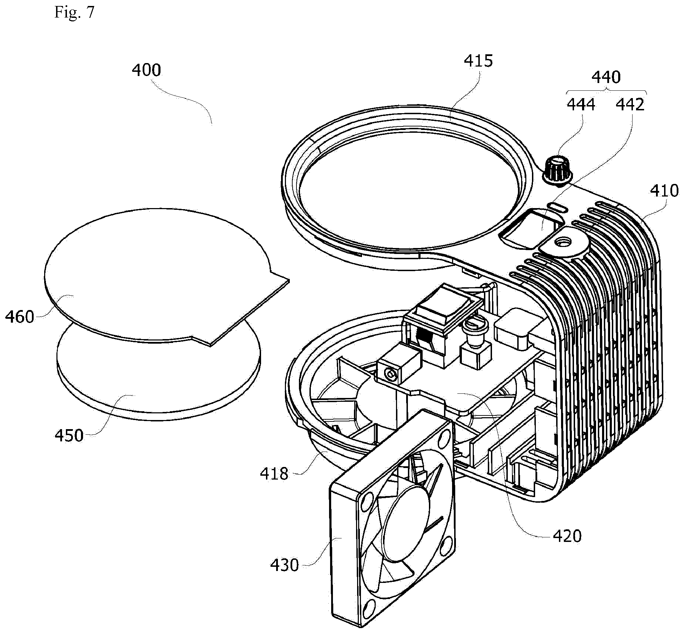

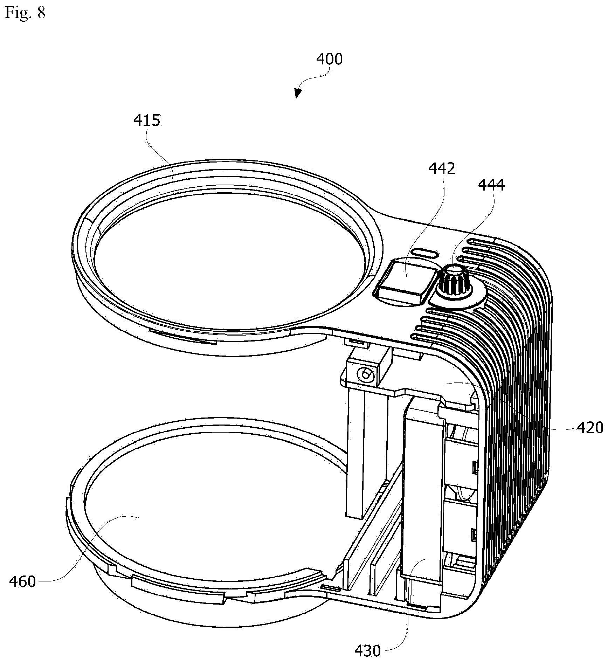

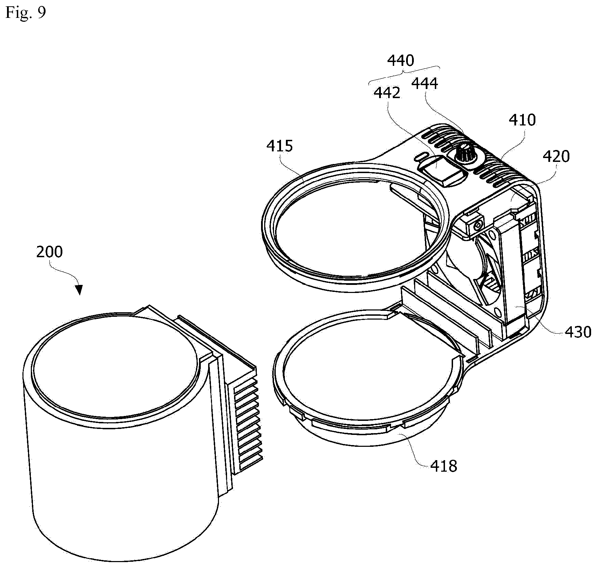

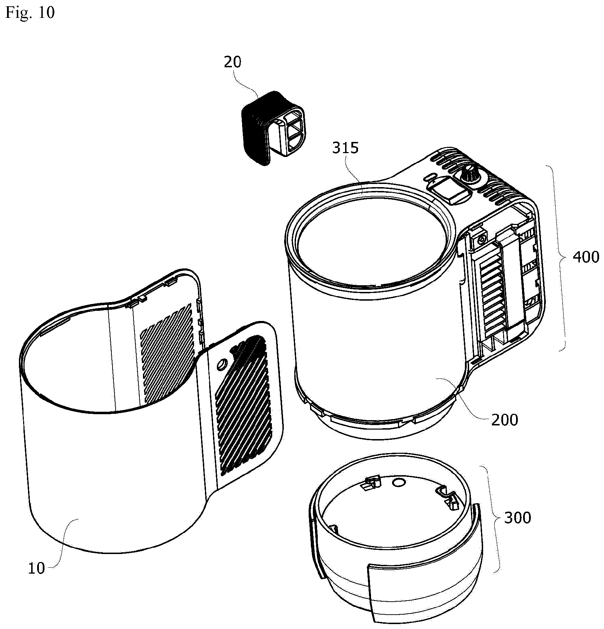

FIG. 7 is an exploded perspective view illustrating a structure of a housing unit 400 of the present apparatus illustrated in FIG. 2, and FIG. 8 is a coupling view of the housing unit in FIG. 7. FIG. 9 is a view of a state of coupling the accommodation unit 200 to the housing unit 400, and FIG. 10 is a view of a state of coupling the extension unit of the present apparatus to the coupling structure in FIG. 9.

Referring to FIGS. 7 to 10, the housing unit 400 of the present apparatus may be provided with an external case 410 in which the accommodation unit of the present apparatus is installed as illustrated in FIG. 7, and a circulation control module 420 which controls the thermoelectric module is included in an inside of the external case.

Particularly, in the external case 410, an upper support portion 415 may be disposed and a lower support portion 418 which supports the accommodation unit from a lower side may be disposed at a lower portion, and the accommodation unit in FIG. 3 may be inserted and fixed between an upper portion and the lower portion thereof.

The circulation control module 420 may include a controller (not shown) which supplies power to the thermoelectric module and controls a signal which drives a blower fan 430 and may be formed in the form of a circuit board including a plurality of passive elements or active elements. The blower fan 430 may be disposed at an inside of the external case 410, and when being coupled to the accommodation unit, may be disposed at a position facing the thermoelectric module, may perform a function of introducing air which has been introduced from the outside onto a heat sink of the thermoelectric module, and simultaneously, may circulate air in an inside of the apparatus. Furthermore, as the external case includes the control switches (442, 444; 440) of the circulation control module at one or more places, control convenience may be obtained.

In addition, as the lower support portion 418 includes a thermal insulation member 450 for thermal insulation and a container supporting plate 460 formed of a thermal conduction member, thermal insulation properties of the present apparatus is improved, and simultaneously, a thermal conversion effect of the thermoelectric module may be effectively transferred to the container accommodation member.

As illustrated in FIG. 9, the accommodation unit 200 of the present apparatus is coupled to the above-described housing unit 400 formed in a coupling structure similar to the structure in FIG. 8, and the above-described extension unit 300 is coupled to a lower portion of the accommodation unit 200, as illustrated in FIG. 10. In this case, a protection case 10 may also be additionally provided to protect an outside of the above-described accommodation unit.

Such a container accommodation apparatus according to the embodiment of the present invention may be provided at various places or positions such as a seat in a vehicle or theater, and a beverage accommodation space of a conference table of a conference room, and may provide a holder having a structure capable of detachably installing in a separate type to improve convenience of use, simultaneously may be coupled to frames having various sizes, and therefore may have versatility of changing an insertion diameter to be easily installed in an existing cup holder.

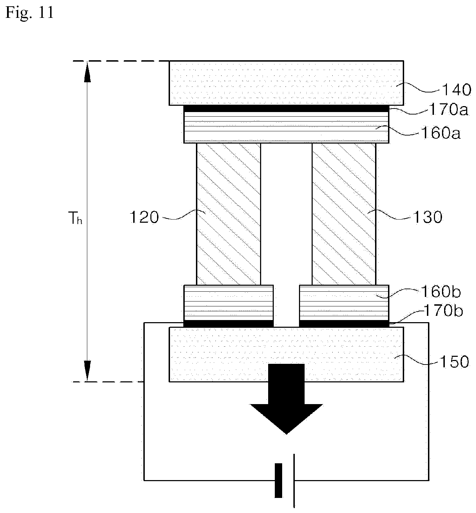

FIG. 11 is a view illustrating a general structure of a thermoelectric module applied to the container accommodation apparatus according to the above-described embodiment of the present invention in the structure in FIG. 2.

The thermoelectric module including a thermoelectric semiconductor element (hereinafter referred to as a 'thermoelectric element') according to the embodiment of the present invention may be formed in a structure including at least one unit cell having a first substrate 140, a second substrate 150, and a second semiconductor element 130 electrically connected to a first semiconductor element 120 between the first substrate 140 and the second substrate 150. In this case, the first substrate 140 and the second substrate 150 may generally include an insulation board such as an alumina board in the case of a thermoelectric module for cooling, or in the case of the embodiment of the present invention, may include a metallic board to improve heat dissipation and to be formed in a thin film type. In a structure in FIG. 2, surfaces of the first substrate 140 and the second substrate 150 may be disposed to be in contact with a surface of the container accommodation portion.

In addition, when the above-described first substrate 140 and second substrate 150 are formed of metallic boards, as illustrated in FIG. 11, it is preferable that dielectric layers 170a and 170b be further formed between electrode layers 160a and 160b which are formed at the first substrate and the second substrate 140 and 150. In the case of a metallic board, Cu or a Cu alloy may be applied thereto, and may be formed in a thickness of in a range of 0.1 mm to 0.5 mm to be formed in a thin film type. In this case, when the metallic board has a thickness less than 0.1 mm or greater than 0.5 mm, heat dissipation property is excessively high or thermal conductivity is too high that reliability of the thermoelectric module is greatly decreased.

In addition, in the case of the dielectric layers 170a and 170b, a material having a thermal conductivity of in a range of 5 to 10 W/K is used as a dielectric material having a high heat dissipation property in consideration of a thermal conductivity of the thermoelectric module for cooling, and a thickness may be in a range of 0.01 mm to 0.15 mm. In this case, when the thickness is less than 0.01 mm, insulation efficiency (or a property of withstanding voltage) is greatly decreased, and when the thickness is greater than 0.15 mm, thermal conductivity is decreased, and therefore heat dissipation efficiency is lowered.

The electrode layers 160a and 160b electrically connect the first semiconductor element and the second semiconductor element using an electrode material such as Cu, Ag, or Ni. The electrode layer may have a thickness in a range of 0.01 mm to 0.3 mm. When the electrode layer has a thickness less than 0.01 mm, a functional property as an electrode is lowered and electric conductivity becomes low, and when the electrode layer has a thickness greater than 0.3 mm, resistance increases and conductivity efficiency decreases.

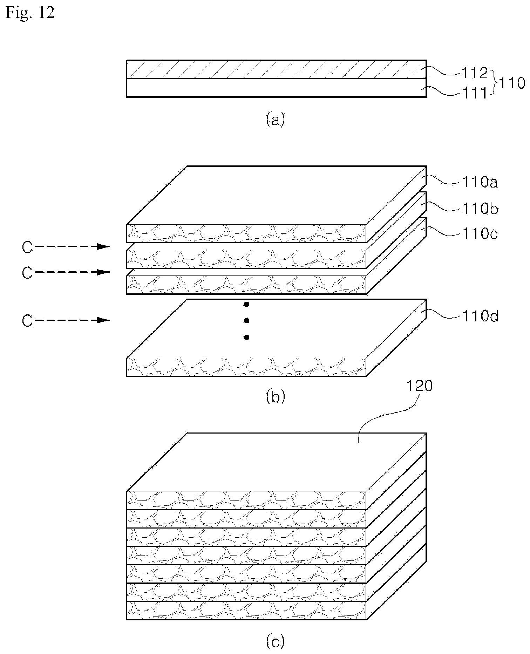

In the case of the thermoelectric module according to the embodiment of the present invention, when a thermoelectric element having the structure in FIG. 11 is formed in a stacked sheet type structure in FIG. 12, a slimmer structure may be formed, and therefore the beverage accommodation container may be formed in a slimmer size. Referring to FIG. 12, a unit thermoelectric element according to the embodiment of the present invention may be basically formed in a stacked structure having a plurality of layers which is formed by a manufacturing process different from that of a bulk type. In a manufacturing process for such a unit thermoelectric element, a material including a semiconductor material is manufactured in a paste type, the paste is coated on a member 111 such as a sheet or a film to form a semiconductor layer 112, and one unit member 110 is formed. As illustrated in FIG. 12, in the unit member 110, a plurality of unit members 100a, 100b, and 100c are stacked to form a stacked structure, and then a unit element 120 is formed by cutting the stacked structure. That is, the unit element 120 according to the present invention may be formed having a structure on which a plurality of unit members 110 are stacked on the member 111, and the semiconductor layer 112 may be stacked on the unit member 110.

In the above-described process, a process in which a semiconductor paste is coated on the member 111 may be realized by various methods, for example, a tape casting method, that is, by mixing a very fine semiconductor powder, a water soluble or insoluble solvent, and any one selected from a binder, a plasticizer, a dispersant, a defoamer, and a surfactant to manufacture a slurry, and formed to have a predetermined thickness on a moving blade or a transferring member according to an objective. In this case, the member may include a material such as a film and a sheet having a thickness in a range of 10 µm to 100 µm, and the coated semiconductor material may include a P-type semiconductor or an N-type semiconductor. In such a P-type semiconductor or an N-type semiconductor, the N-type semiconductor element may be formed with a mixture in which a main raw material formed of a bismuth (Bi) telluride (Te)-based material including selenium (Se), nickel (Ni), aluminum (Al), copper (Cu), silver (Ag), lead (Pb), boron (B), gallium (Ga), tellurium (Te), bismuth (Bi), or indium (In), and Bi or Te whose amount corresponds to a range of 0.001 to 1.0 wt% of an entire weight of the main raw material are mixed. For example, the N-type semiconductor element may be formed by adding Bi or Te whose amount is in a range of 0.001 to 1.0 wt% of an entire weight of Bi-Se-Te which is a main raw material thereof. That is, when 100 g of Bi-Se-Te is input, it is preferable that Bi or Te of in a range of 0.001 g to 1.0 g be input additionally. As described above, it is significant that thermal conductivity may not be lowered, electric conductivity may be lowered, and therefore improvement of ZT value may not be expected when an amount of a material added to the above-described main raw material is out of a range of 0.001 wt% to 0.1 wt% thereof.

It is preferable that the P-type semiconductor element be formed with a mixture in which a main raw material formed of a BiTe-based material including Sb, Ni, Al, Cu, Ag, Pb, B, Ga, Te, Bi, and In, and Bi or Te whose amount is in a range of 0.001 to 1.0 wt% of an entire weight of the main raw material are mixed. For example, the P-type semiconductor element may be formed by adding Bi or Te whose amount is in a range of 0.001 to 1.0 wt% of an entire weight of Bi-Se-Te which is a main raw material thereof. That is, when 100 g of Bi-Se-Te is input, Bi or Te whose amount is in a range of 0.001 g to 1.0 g may be input additionally. It is significant that thermal conductivity may not be lowered, electric conductivity may be lowered, and therefore improvement of ZT value may not be expected when an amount of a material added to the above-described main raw material is out of a range of 0.001 wt% to 0.1 wt% thereof.

In addition, a process in which the unit members 110 are stacked by aligning in multiple layers may be performed by pressing the unit members 110 at a temperature in a range of 50 °C to 250 °C and a stacked structure may be formed. In the present embodiment, the number of stacked unit members 110 may be in a range of 2 to 50. After that, a cutting process may be performed for a desired shape and size, and a sintering process may be added.

The unit element formed by stacking the plurality of unit members 110 manufactured according to the above-described process may have a uniform thickness and a uniform shape. That is, in a conventional thermoelectric element having a bulk type, since a sintered bulk structure is cut after ingot pulverizing and fine ball-mill processes, much material is lost in the cutting process and it is also difficult to cut to a uniform thickness and to make a thin film type due to a thick thickness of in a range of 3 mm to 5 mm. However, in the unit element having the stacked structure according to the embodiment of the present invention, since a sheet stacked structure is cut after multiple layers of unit members having a sheet type are stacked, there is almost no material loss, uniformity of a material may be obtained because the material has a uniform thickness, the material may have a thin film type because a total thickness of the unit elements is also 1.5 mm or less, and the material may be applied in various shapes.

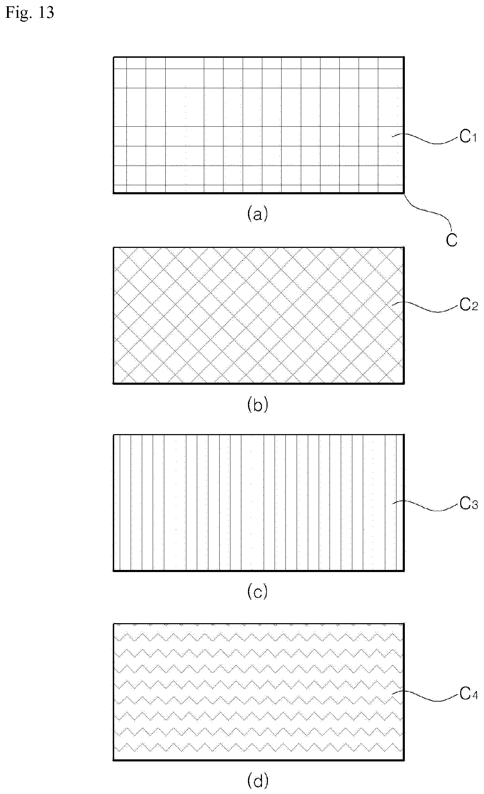

Particularly, in a manufacturing process of the unit element according to the embodiment of the present invention, the process in which the stacked structure of the unit member 110 is formed may further include a process in which a conductive layer is formed on each surface of the unit members 110. That is, the conductive layer such as a structure in FIG. 13 may be formed between the unit members having stacked structures in FIG. 12C. The conductive layer may be formed at a surface opposite to a member surface on which a semiconductor layer is formed. In this case, the conductive layer may be formed to have a patterned layer so that an area in which a surface of the unit member is exposed is formed. This may cause electric conductivity to be increased more than when the conductive layer is coated on the entire surface, and simultaneously, there may be advantages in that a bonding force between the unit members is improved and thermal conductivity is also decreased.

That is, FIG. 13 is a view illustrating variously changed embodiments of a conductive layer C according to the embodiment of the present invention. A pattern in which the surface of the unit member is exposed may be variously varied and designed in a mesh type structure including a closed open pattern c1, c2 as illustrated in FIGS. 13A and 13B, or a line type structure including an opened open pattern c3, c4 as illustrated in FIGS. 13C and 13D. The above-described conductive layer has an advantage in that a bonding force between the unit members in the unit element formed in a stacked structure of the unit members is increased, and electric conductivity between the unit members is also increased. In addition, the above-described conductive layer improves a cooling capacity (Qc) and ΔT °C compared with a conventional bulk type thermoelectric element, and particularly increases a power factor by 1.5 times, that is, electric conductivity by 1.5 times. Since the increase of electric conductivity is directly related to improvement of thermoelectric efficiency, cooling efficiency thereof is improved.

The conductive layer may be formed of a metal material, and all metal based electrode materials having materials such as Cu, Ag, and Ni may be applied thereto.

When the thermoelectric element of the structure in FIGS. 12 and 13 is applied to the beverage accommodation apparatus for a vehicle according to the embodiment of the present invention, thermoelectric efficiency may be increased, and simultaneously, a degree of design freedom at which a size of an entire apparatus can be easily decreased or increased to a desired size may be obtained.

Specific embodiments of the preset invention have been described above in detail. The embodiments can be variously modified without departing from the scope of the present invention. Therefore, the scope of the present invention is defined not by the described embodiments but by the appended claims, and encompasses equivalents that fall within the scope of the appended claims.

### [Reference Numerals]

100: THERMOELECTRIC MODULE
200: ACCOMMODATION UNIT
300: EXTENSION UNIT
400: HOUSING UNIT

## Claims

1. A container accommodation apparatus comprising:
an accommodation unit (200) including a container accommodation member (210) configured to accommodate a container therein and a thermoelectric module (100) which is disposed at an external surface of the container accommodation member (210) and applies thermal conversion effect;
an extension unit (300) which is coupled to a lower portion of the accommodation unit (200), and fixes and supports the accommodation unit; and
a housing unit (400) which includes a circulation control module (420) which performs control of the thermoelectric module (100), and in which the accommodation unit is installed,
**characterized in that** the extension unit (300) includes:
a case member (310) which is coupled to a lower side of the container accommodation member (210), and in which an extension slot (311) communicated with an inner portion thereof is formed; and
a stopper member (320) provided in a structure to be inserted into the case member (310) through the extension slot (311) of the case member.

2. The container accommodation apparatus of claim 1, wherein the stopper member includes:
a first member (322) inserted into an inside from an outside of the case member (310); and
a second member (324) formed at one end of the first member (322) and disposed at the outside of the case member (310).

3. The container accommodation apparatus of claim 2, wherein the extension unit (300) further includes a protection cover (350) which covers a surface of an upper portion of the case member (310).

4. The container accommodation apparatus of claim 2, wherein the first member (322) includes a stopper pattern (326).

5. The container accommodation apparatus of claim 4, wherein the second member (324) surrounds a part of an outer circumferential surface of the case member (310) and is formed to be larger than the extension slot (300).

6. The container accommodation apparatus of claim 4, wherein the extension unit (300) further includes a gear member (340) which is disposed in the case member (310) and engaged with the stopper pattern (326).

7. The container accommodation apparatus of claim 6, wherein the extension unit (300) further includes an elastic member (360) which is formed at the first member (322) and applies an elastic restoring force to the first member when the stopper pattern (326) is engaged with the gear member (360).

8. The container accommodation apparatus of claim 2, wherein the stopper member (320) is formed in a pair.

9. The container accommodation apparatus of claim 1, wherein the circulation control module (420) includes:
a blower fan (430) disposed at a position facing a heating portion on the thermoelectric module; and
a controller which controls applying of power to the blower fan and the thermoelectric module.

10. The container accommodation apparatus of claim 1, wherein a thermoelectric module seating portion (215) is provided at a side surface of the container accommodation member (210), and the container accommodation apparatus further includes a first thermal insulation member (230) installed at an outer circumferential surface of the thermoelectric module (100) seated on the thermoelectric module seating portion.

11. The container accommodation apparatus of claim 10, further comprising a heat sink (190) disposed on an outer circumferential surface of the first thermal insulation member (230) and on a substrate of a heating portion of the thermoelectric module.

12. The container accommodation apparatus of claim 10, wherein the accommodation unit further includes a second thermal insulation member (230) which surrounds an external surface of the container accommodation member (210).

13. The container accommodation apparatus of claim 1, wherein the housing unit (400) further includes an external case configured to install the accommodation unit.

14. The container accommodation apparatus of claim 13, wherein the circulation control module (420) is disposed in the external case.

15. The container accommodation apparatus of claim 14, further comprising a control switch (422) which is disposed in the external case and controls the circulation control module (420).

## Patentansprüche

1. Behälteraufnahmevorrichtung umfassend:
eine Aufnahmeeinheit (200) umfassend ein Behälteraufnahmeelement (210), das dazu konfiguriert ist, einen Behälter darin aufzunehmen, und ein thermoelektrisches Modul (100), das an einer äußeren Oberfläche des Behälteraufnahmeelements (210) angeordnet ist und eine thermische Umwandlungswirkung ausübt;
eine Erstreckungseinheit (300), die mit einem unteren Abschnitt der Aufnahmeeinheit (200) gekoppelt ist, und die Aufnahmeeinheit fixiert und trägt; und
eine Gehäuseeinheit (400), die ein Zirkulationssteuerungsmodul (420) umfasst, das eine Steuerung des thermoelektrischen Moduls (100) durchführt, und in der die Aufnahmeeinheit installiert ist,
**dadurch gekennzeichnet, dass** die Erstreckungseinheit (300) umfasst:
ein Gehäuseelement (310), das mit einer unteren Seite des Behälteraufnahmeelements (210) gekoppelt ist, und in dem ein mit einem inneren Abschnitt davon in Verbindung stehender Erstreckungsschlitz (311) gebildet ist; und
ein Anschlagelement (320), das in einer Struktur vorgesehen ist, die durch den Erstreckungsschlitz (311) des Gehäuseelements in das Gehäuseelement (310) einzufügen ist.

2. Behälteraufnahmevorrichtung nach Anspruch 1, wobei das Anschlagelement umfasst:
ein erstes Element (322), das von einer Außenseite des Gehäuseelements (310) in eine Innenseite eingefügt ist; und
ein zweites Element (324), das an einem Ende des ersten Elements (322) gebildet und an der Außenseite des Gehäuseelements (310) angeordnet ist.

3. Behälteraufnahmevorrichtung nach Anspruch 2, wobei die Erstreckungseinheit (300) ferner eine Schutzabdeckung (350) umfasst, die eine Oberfläche eines oberen Abschnitts des Gehäuseelements (310) abdeckt.

4. Behälteraufnahmevorrichtung nach Anspruch 2, wobei das erste Element (322) ein Anschlagmuster (326) umfasst.

5. Behälteraufnahmevorrichtung nach Anspruch 4, wobei das zweite Element (324) einen Teil einer Außenumfangsoberfläche des Gehäuseelements (310) umgibt und so gebildet ist, dass es größer als der Erstreckungsschlitz (311) ist.

6. Behälteraufnahmevorrichtung nach Anspruch 4, wobei die Erstreckungseinheit (300) ferner ein Zahnradelement (340) umfasst, das in dem Gehäuseelement (310) angeordnet ist und mit dem Anschlagmuster (326) in Eingriff steht.

7. Behälteraufnahmevorrichtung nach Anspruch 6, wobei die Erstreckungseinheit (300) ferner ein elastisches Element (360) umfasst, das an dem ersten Element (322) gebildet ist und eine elastische Rückstellkraft auf das erste Element aufbringt, wenn das Anschlagmuster (326) mit dem Zahnradelement (340) in Eingriff steht.

8. Behälteraufnahmevorrichtung nach Anspruch 2, wobei das Anschlagelement (320) paarweise gebildet ist.

9. Behälteraufnahmevorrichtung nach Anspruch 1, wobei das Zirkulationssteuerungsmodul (420) umfasst:
ein Gebläse (430), das an einer einem Heizabschnitt zugewandten Position an dem thermoelektrischen Modul angeordnet ist; und
eine Steuereinrichtung, die ein Anlegen von Leistung an das Gebläse und das thermoelektrische Modul steuert.

10. Behälteraufnahmevorrichtung nach Anspruch 1, wobei ein Thermoelektromodul-Platzierungsabschnitt (215) an einer Seitenoberfläche des Behälteraufnahmeelements (210) vorgesehen ist, und die Behälteraufnahmevorrichtung ferner ein erstes thermisches Isolierelement (230) umfasst, das an einer Außenumfangsoberfläche des an dem Thermoelektromodul-Platzierungsabschnitt platzierten thermoelektrischen Moduls (100) installiert ist.

11. Behälteraufnahmevorrichtung nach Anspruch 10, ferner umfassend eine Wärmesenke (190), die an einer Außenumfangsoberfläche des ersten thermischen Isolierelements (230) und an einem Substrat eines Heizabschnitts des thermoelektrischen Moduls angeordnet ist.

12. Behälteraufnahmevorrichtung nach Anspruch 10, wobei die Aufnahmeeinheit ferner ein zweites thermisches Isolierelement (220) umfasst, das eine äußere Oberfläche des Behälteraufnahmeelements (210) umgibt.

13. Behälteraufnahmevorrichtung nach Anspruch 1, wobei die Gehäuseeinheit (400) ferner ein äußeres Gehäuse umfasst, das dazu konfiguriert ist, die Aufnahmeeinheit zu installieren.

14. Behälteraufnahmevorrichtung nach Anspruch 13, wobei das Zirkulationssteuerungsmodul (420) in dem äußeren Gehäuse angeordnet ist.

15. Behälteraufnahmevorrichtung nach Anspruch 14, ferner umfassend einen Steuerungsschalter (444), der in dem äußeren Gehäuse angeordnet ist und das Zirkulationssteuerungsmodul (420) steuert.

## Revendications

1. Un appareil de logement de récipient comprenant :
une unité de logement (200) incluant un élément (210) de réception de récipient configuré pour recevoir un récipient à l'intérieur de lui et un module thermoélectrique (100) qui est disposé sur une surface externe de l'élément (210) de réception de récipient et applique un effet de conversion thermique ;
une unité d'extension (300) qui est reliée à une partie inférieure de l'unité de logement (200), et qui fixe et supporte l'unité de logement ; et
une unité de logement (400) qui comprend un module (420) de commande de circulation qui effectue la commande du module thermoélectrique (100) et dans lequel l'unité de logement est installée,
**caractérisé en ce que** l'unité d'extension (300) comprend :
un élément formant réceptacle (310) qui est relié à un côté inférieur de l'élément (210) de réception de récipient, et dans lequel une fente d'extension (311) communiquant avec une partie interne de celui-ci est formée ; et
un organe d'arrêt (320) prévu dans une structure destinée à être insérée dans l'élément formant réceptacle (310) à travers la fente d'extension (311) de l'élément formant réceptacle.

2. L'appareil de logement de récipient selon la revendication 1, dans lequel l'organe d'arrêt comprend :
un premier élément (322) inséré dans un intérieur à partir d'un extérieur de l'élément formant réceptacle (310) ; et
un deuxième élément (324) formé à une extrémité du premier élément (322) et disposé à l'extérieur de l'élément formant réceptacle (310).

3. L'appareil de logement de récipient selon la revendication 2, dans lequel l'unité d'extension (300) comprend en outre un couvercle de protection (350) qui recouvre une surface d'une partie supérieure de l'élément formant réceptacle (310).

4. L'appareil de logement de récipient selon la revendication 2, dans lequel le premier élément (322) comprend une configuration d'arrêt (326).

5. L'appareil de logement de récipient selon la revendication 4, dans lequel le deuxième élément (324) entoure une partie d'une surface circonférentielle extérieure de l'élément formant réceptacle (310) et est formé de façon à être plus grand que la fente d'extension (300).

6. L'appareil de logement de récipient selon la revendication 4, dans lequel l'unité d'extension (300) comprend en outre un organe d'engrenage (340) qui est disposé dans l'élément formant réceptacle (310) et en prise avec la configuration d'arrêt (326).

7. L'appareil de logement de récipient selon la revendication 6, dans lequel l'unité d'extension (300) comprend en outre un organe élastique (360) qui est formé au niveau du premier élément (322) et applique une force de rappel élastique au premier élément lorsque la configuration d'arrêt (326) est en prise avec l'organe d'engrenage (360).

8. L'appareil de logement de récipient selon la revendication 2, dans lequel l'organe d'arrêt (320) est formé en une paire.

9. L'appareil de logement de récipient selon la revendication 1, dans lequel le module (420) de commande de circulation comprend :
un ventilateur de soufflante (430) disposé en une position faisant face à une partie de chauffage présente sur le module thermoélectrique ; et
un contrôleur qui commande l'application d'une puissance au ventilateur de soufflante et au module thermoélectrique.

10. L'appareil de logement de récipient selon la revendication 1, dans lequel une partie (215) formant siège de module thermoélectrique est prévue au niveau d'une surface latérale de l'élément (210) de logement de récipient, et l'appareil de logement de récipient comprend en outre un premier élément (230) d'isolation thermique installé au niveau d'une surface circonférentielle extérieure du module thermoélectrique (100) placée sur la partie formant siège de module thermoélectrique.

11. L'appareil de logement de récipient selon la revendication 10, comprenant en outre un dissipateur de chaleur (190) disposé sur une surface circonférentielle extérieure du premier élément d'isolation thermique (230) et sur un substrat d'une partie chauffante du module thermoélectrique.

12. L'appareil de logement de récipient selon la revendication 10, dans lequel l'unité de logement comprend en outre un deuxième élément d'isolation thermique (230) qui entoure une surface externe de l'élément (210) de réception de récipient.

13. L'appareil de logement de récipient selon la revendication 1, dans lequel l'unité de logement (400) inclut en outre un réceptacle externe configuré pour installer l'unité de logement.

14. L'appareil de logement de récipient selon la revendication 13, dans lequel le module (420) de commande de circulation est disposé dans le réceptacle externe.

15. L'appareil de logement de récipient selon la revendication 14, comprenant en outre un commutateur de commande (422) qui est disposé dans le réceptacle externe et qui commande le module (420) de commande de circulation.
